# DEMANDE DE BREVET EUROPEEN

(11) **EP 1 734 536 A1**
(43) Date de publication de la demande: **20.12.2006**
(21) Numéro de dépôt: 06011029.3
(22) Date de dépôt: 30.05.2006
(51) Int. Cl.: G11C 16/22, G11C 8/20, G11C 7/24

(54) **Mémoire protégée contre des attaques par injection d'erreur dans des signaux de sélection de cellules mémoire**

(30) Priorité: 15.06.2005 FR 0506034
(71) Demandeur: STMicroelectronics SA, 92210 Montrouge (FR)
(72) Inventeur: Wuidart, Sylvie, 83910 Pourrieres (FR); Demange, Nicolas, 83470 Saint Maximin La Sainte Baume (FR); Lisart, Mathieu, 13100 Aix en Provence (FR)
(74) Mandataire: Marchand, André

(57) **Abrégé**

L'invention concerne une mémoire (1) comprenant des cellules mémoire (MC) agencées dans un plan mémoire (MA), et un décodeur d'adresse (ADEC) pour appliquer au plan mémoire des signaux (Si) de sélection de cellules mémoire (MC) en fonction d'une adresse de lecture (ADi, ADH, ADL) appliquée à la mémoire. Selon l'invention, la mémoire comprend un circuit de reconstitution d'adresse (ARCT) qui reconstitue au moins une partie de l'adresse de lecture (ADi) à partir des signaux (Si) de sélection de cellules mémoire, et fournit une première adresse reconstituée (RADi) permettant de détecter une injection d'erreur affectant les signaux de sélection. Application notamment aux circuits intégrés pour cartes à puces.

## Description

La présente invention concerne la protection des circuits intégrés contre les attaques par injection d'erreur, et notamment la protection des circuits intégrés pour cartes à puce.

La présente invention concerne plus particulièrement un procédé pour sécuriser la lecture d'une mémoire dans un circuit intégré, et s'applique notamment aux mémoires non volatiles telles que les mémoires ROM, EEPROM et FLASH.

Ces dernières années, les techniques de piratage des circuits intégrés sécurisés ont considérablement évolué. A l'heure actuelle, les méthodes de piratage les plus avancées consistent à injecter des erreurs en des points déterminés d'un circuit intégré lors de l'exécution d'opérations dites sensibles, par exemple des opérations d'authentification ou des opérations d'exécution d'un algorithme de cryptographie. De telles attaques par injection d'erreur, appelées également attaques par injection de faute, permettent, en combinaison avec des modèles mathématiques, de déduire la structure d'un algorithme de cryptographie à logique câblée et/ou les clefs secrètes qu'il utilise. L'injection d'erreur peut être faite de diverses manières, en introduisant des perturbations ("glitches") dans la tension d'alimentation du circuit intégré, en introduisant des perturbations dans le signal d'horloge du circuit intégré, en exposant le circuit intégré à des radiations ou un faisceau laser, etc.

Les mémoires présentes dans ces circuits intégrés sont particulièrement visées par ce type d'attaque, car elles contiennent des données confidentielles (clés secrètes, mots de passe...) que le fraudeur cherche à connaître.

Afin de détecter un défaut d'intégrité dans une mémoire, c'est-à-dire la présence de données non valides, il est connu de procéder à des vérifications du contenu d'une mémoire, par exemple au démarrage du circuit intégré ou lorsque la mémoire est accédée en lecture ou en écriture. Toutefois, de telles vérifications ne permettent pas de détecter des attaques qui ne modifient pas le contenu de la mémoire et qui conduisent seulement la mémoire à lire des données qui ne sont pas celles que l'on souhaite lire.

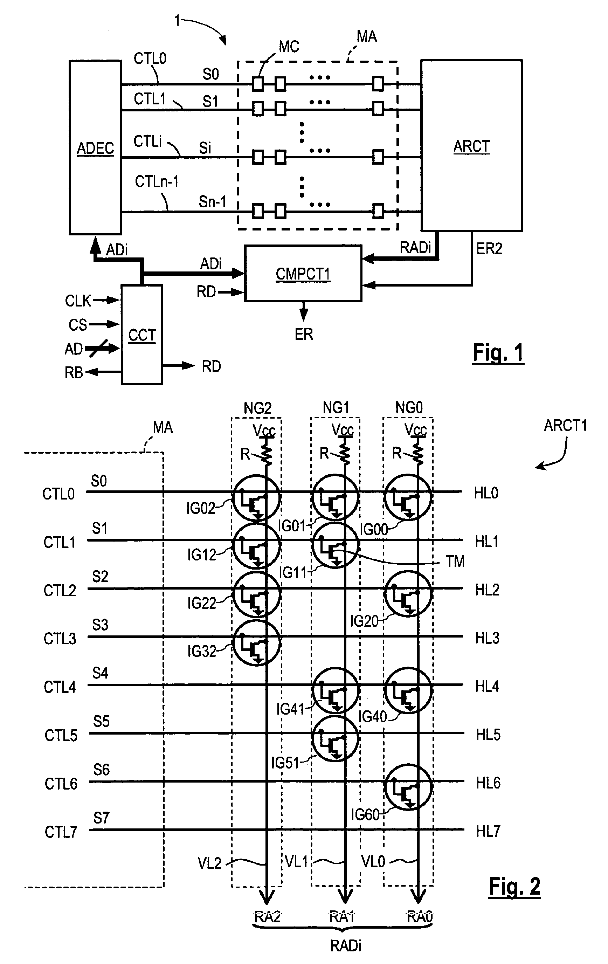

Ce type d'attaque sera mieux compris en se référant à la figure 1, qui représente une mémoire 1 comprenant des cellules mémoire MC agencées dans un plan mémoire MA et reliées par des fils de contrôle CTLi à au moins un décodeur d'adresse ADEC. Le décodeur ADEC applique aux fils contrôle CTLi des signaux Si de sélection de cellules mémoire qui sont fonction d'une adresse ADi appliquée à la mémoire.

Lorsqu'une erreur visant à fausser la lecture d'une donnée est injectée dans la mémoire, l'erreur injectée vise généralement le décodeur d'adresse et provoque un dysfonctionnement de celui-ci qui se répercute sur les signaux de sélection Si, de sorte que les cellules mémoire sélectionnées et les données lues dans le plan mémoire ne sont pas celles qui correspondent à l'adresse ADi.

Les documents US 3 049 692 et US 4 912 710 décrivent une mémoire comportant un décodeur d'adresse fournissant des signaux de sélection de cellules mémoire à partir d'une adresse, et un encodeur d'adresse reconstituant une adresse à partir des signaux de sélection appliqués aux cellules mémoire. L'adresse d'origine et l'adresse reconstituée sont ensuite comparées. Le document US 3 049 692 reconstitue l'adresse à partir des signaux de sélection de cellules mémoire à l'aide de noyaux magnétiques.

Un objectif de la présente invention est de prévoir un moyen simple permettant de contrer des attaques visant à perturber les signaux de sélection de cellules mémoire.

Pour atteindre cet objectif, la présente invention propose de reconstituer l'adresse d'une donnée lue dans le plan mémoire à partir des signaux de sélection appliqués au plan mémoire. La reconstitution d'adresse est de préférence effectuée en temps réel, c'est-à-dire au moment où la donnée est lue et tant que les signaux de sélection sont présents. Une telle reconstitution d'adresse permet de vérifier que l'adresse reconstituée, qui est l'adresse réelle de la donnée lue dans le plan mémoire, correspond à l'adresse appliquée à la mémoire.

Plus particulièrement, la présente invention prévoit un procédé de lecture d'une donnée dans une mémoire comprenant des cellules mémoire agencées dans un plan mémoire, comprenant une étape d'application au plan mémoire de signaux de sélection de cellules mémoire en fonction d'une adresse de lecture appliquée à la mémoire, et une étape de reconstitution d'au moins une partie de l'adresse de lecture à partir des signaux de sélection de cellules mémoire, pour obtenir une première adresse reconstituée.

Selon un mode de réalisation, un bit de l'adresse reconstituée est reconstitué au moyen d'interrupteurs agencés pour polariser à un premier état logique un noeud de sortie commun polarisé par défaut à un second état logique, et en appliquant les signaux de sélection de cellules mémoire sur des bornes de contrôle des interrupteurs.

Selon un mode de réalisation, le procédé comprend les étapes consistant à comparer la première adresse reconstituée avec au moins une partie de l'adresse de lecture, et activer un premier signal d'erreur si l'adresse reconstituée est différente de l'adresse de lecture.

Selon un mode de réalisation, le procédé comprend les étapes consistant à produire, à partir des signaux de sélection, une seconde adresse reconstituée qui forme le complément à 1 de la première adresse reconstituée, comparer la première et la seconde adresses reconstituées, et activer un second signal d'erreur si au moins l'un des bits de la seconde adresse reconstituée est égal à un bit de même rang de la première adresse reconstituée.

Selon un mode de réalisation, le procédé comprend l'activation d'un signal d'erreur général si au moins l'un des deux signaux d'erreur est activé.

Selon un mode de réalisation, l'adresse reconstituée comprend le même nombre de bits que l'adresse de lecture.

Selon un mode de réalisation, les signaux de sélection sont transformés en signaux basse tension avant d'être appliqués aux bornes de contrôle des interrupteurs.

Selon un mode de réalisation, le procédé est appliqué à une mémoire comprenant un plan mémoire comportant des cellules mémoire connectées à des lignes de mot et à des lignes de bit, les lignes de bit étant agencées en colonnes pour former des colonnes, un décodeur de ligne fournissant des signaux de sélection de ligne de mot en fonction de l'adresse de lecture, un décodeur de colonne fournissant des signaux de sélection de colonne en fonction de l'adresse de lecture, et l'adresse reconstituée est déterminée à la fois à partir des signaux de sélection de ligne de mot et des signaux de sélection de colonne.

L'invention concerne également une mémoire comprenant des cellules mémoire agencées dans un plan mémoire, un décodeur d'adresse pour appliquer au plan mémoire des signaux de sélection de cellules mémoire en fonction d'une adresse de lecture appliquée à la mémoire, et un circuit de reconstitution d'adresse qui fournit une première adresse reconstituée reconstituant au moins une partie de l'adresse de lecture à partir des signaux de sélection de cellules mémoire,.

Selon un mode de réalisation, le circuit de reconstitution d'adresse comprend au moins un groupe d'interrupteurs agencés pour polariser à un premier état logique, un noeud de sortie commun aux interrupteurs, qui fournit un bit de l'adresse reconstituée, un élément pour polariser par défaut le noeud de sortie à un second état logique, et des moyens pour appliquer directement ou indirectement à des bornes de contrôle des interrupteurs des signaux de sélection de cellules mémoire.

Selon un mode de réalisation, la mémoire comprend un circuit de comparaison qui compare l'adresse reconstituée avec au moins une partie de l'adresse de lecture, et qui active un premier signal d'erreur si l'adresse reconstituée est différente de l'adresse de lecture.

Selon un mode de réalisation, le circuit de reconstitution d'adresse fournit également une seconde adresse reconstituée qui forme le complément à 1 de la première adresse reconstituée.

Selon un mode de réalisation, la mémoire comprend un circuit de comparaison qui compare la première et la seconde adresses reconstituées, et active un second signal d'erreur si au moins l'un des bits de la seconde adresse reconstituée est égal à un bit de même rang de la première adresse reconstituée.

Selon un mode de réalisation, le circuit de reconstitution d'adresse comprend des modules de reconstitution d'adresse ayant des sorties communes et fonctionnant en alternance pour fournir en alternance différentes parties de l'adresse reconstituée.

Selon un mode de réalisation, la mémoire comprend un plan mémoire comportant des cellules mémoire connectées à des lignes de mot et à des lignes de bit, les lignes de bit étant agencées en colonnes pour former des colonnes de mot, un décodeur de ligne fournissant des signaux de sélection de ligne de mot en fonction de l'adresse de lecture, un décodeur de colonne fournissant des signaux de sélection de colonne en fonction de l'adresse de lecture, un circuit de reconstitution d'une adresse de ligne de mot, fournissant une adresse de ligne de mot reconstituée à partir des signaux de sélection de ligne de mot, et un circuit de reconstitution d'une adresse de colonne, fournissant une adresse de colonne reconstituée à partir des signaux de sélection de colonne.

Selon un mode de réalisation, la mémoire comprend un circuit d'interface pour isoler le circuit de reconstitution d'adresse des signaux de sélection appliqués au plan mémoire lorsque la mémoire n'est pas en phase de lecture du plan mémoire.

Selon un mode de réalisation, la mémoire comprend un circuit d'interface pour abaisser la tension des signaux de sélection appliqués au plan mémoire avant de les appliquer au circuit de reconstitution d'adresse.

Selon un mode de réalisation, le circuit d'interface comprend des composants de cellules mémoire non utilisées présentes sur des bords du plan mémoire.

Ces objets, caractéristiques et avantages ainsi que d'autres de la présente invention seront exposés plus en détail dans la description suivante de l'invention faite à titre non limitatif en relation avec les figures jointes parmi lesquelles :
- la figure 1 décrite partiellement ci-dessus représente de façon schématique une mémoire comprenant un dispositif de surveillance de lecture selon l'invention,
- la figure 2 représente un exemple de réalisation d'un circuit de reconstitution d'adresse selon l'invention représenté sous forme de bloc en figure 1,
- la figure 3 représente un autre mode de réalisation d'un circuit de reconstitution d'adresse selon l'invention,
- la figure 4 est le schéma logique d'un circuit de comparaison présent dans le dispositif de surveillance de la figure 1,
- la figure 5 représente de façon plus détaillée une mémoire comprenant un dispositif de surveillance selon l'invention,
- la figure 6 représente schématiquement un exemple de réalisation d'un circuit d'interface présent dans la mémoire de la figure 5,
- la figure 7 représente un autre mode de réalisation du circuit d'interface, et
- la figure 8 représente schématiquement encore un autre mode de réalisation d'un circuit de reconstitution d'adresse selon l'invention.

La figure 1 décrite partiellement plus haut représente une mémoire 1 d'architecture classique comprenant un plan mémoire MA, un décodeur d'adresse ADEC et un circuit de contrôle CCT.

Le plan mémoire MA comprend des cellules mémoire MC connectées à des lignes de contrôle CTLi, i étant un indice variant de 0 à n-1, n étant le nombre de lignes de contrôle de la mémoire. Le circuit de contrôle CCT reçoit une adresse AD de lecture, un signal d'horloge CLK et un signal CS (Chip Select) de sélection la mémoire. Il fournit un signal interne RD (Read) de déclenchement de lecture, un signal externe d'occupation RB (Ready/Busy) qui indique si la mémoire est occupée ou non, et applique au décodeur ADEC une adresse ADi qui est fonction de l'adresse AD reçue. Sur réception de l'adresse ADi et du signal de lecture RD, le décodeur ADEC applique aux lignes de contrôle CTLi des signaux de sélection Si (S0 à Sn-1) qui permettent de sélectionner en lecture une ou plusieurs cellules mémoire désignées par l'adresse ADi.

Selon l'invention, la mémoire 1 comprend un dispositif de surveillance de lecture comprenant un circuit de reconstitution d'adresse ARCT et un circuit de comparaison d'adresse CMPCT1.

Le circuit ARCT fournit une adresse reconstituée RADi qui est élaborée en temps réel à partir des signaux de sélection Si appliqués par le décodeur ADEC au plan mémoire MA. Le circuit de comparaison CMPCT1 compare l'adresse ADi appliquée au décodeur ADEC et l'adresse reconstituée RADi, de préférence à la volée pour éviter le recours à des moyens de stockage d'adresse, et fournit un signal d'erreur ER représentatif du résultat de la comparaison. Le signal ER est par exemple égal à 0 si les adresses ADi et RADi sont identiques, et égal à 1 si elles sont différentes.

Le signal d'erreur ER peut être utilisé de diverses manières. Le signal d'erreur ER est par exemple appliqué au circuit de contrôle CCT qui place la mémoire en mode d'erreur quand le signal d'erreur passe à 1 à la fin d'une opération de lecture. En mode d'erreur, le circuit de contrôle CCT émet par exemple un signal d'erreur externe (non représenté) à l'attention d'une unité de traitement, laquelle peut décider de remettre à zéro l'ensemble du circuit dans lequel la mémoire est incorporée (une telle remise à zéro générale étant souhaitable avec un circuit intégré pour carte à puce).

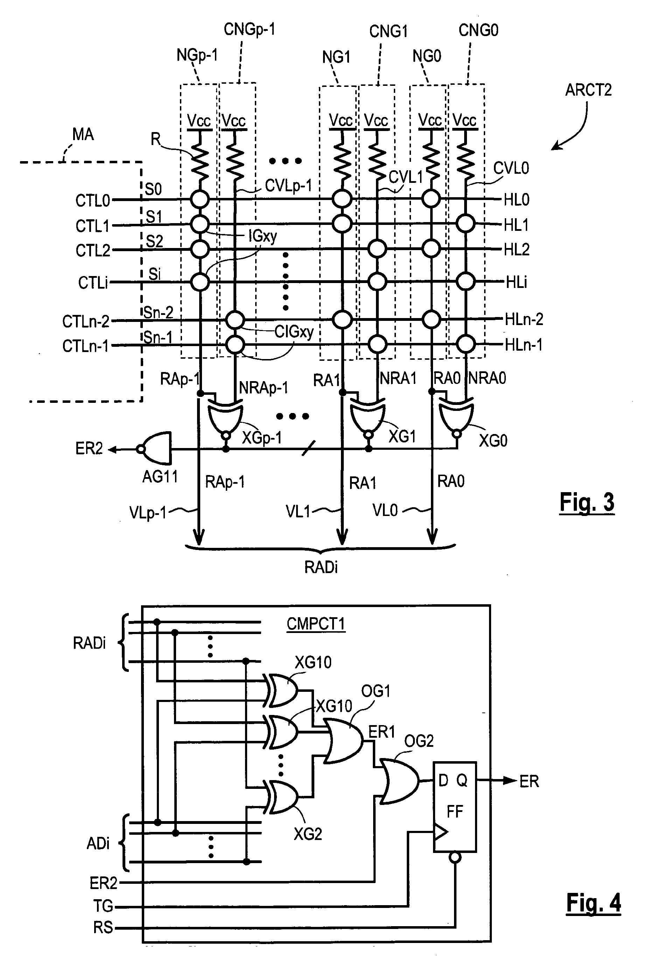

La figure 2 représente un exemple de réalisation ARCT1 d'un circuit de reconstitution d'adresse selon l'invention, dans l'hypothèse simplificatrice où le plan mémoire MA ne comprend que 8 lignes de contrôle CTL0 à CTL7. Dans ce cas, le décodeur ADEC reçoit une adresse ADi de trois bits A2, A1, A0 et fournit huit signaux de sélection S0 à S7 appliqués aux lignes de contrôle CTL0 à CTL7.

La structure du circuit ARCT1 est déterminée à partir de la fonction de décodage exécutée par le décodeur ADEC, décrite par le tableau 1 ci-après (Cf. Annexe). Cette fonction de décodage définit la valeur des signaux de sélection S0 à S7 en fonction de la valeur des bits d'adresse A2, A1, A0. On considère ici qu'un signal de sélection S0 à S7 est mis à 1 (valeur active) lorsque la ligne de contrôle correspondante CTL0 à CTL7 est désignée par l'adresse ADi.

Pour déterminer la fonction de reconstitution d'adresse, ou fonction d'encodage d'adresse, que doit réaliser le circuit ARCT2, les tableaux 2, 3 et 4 ci-après (Cf. Annexe) sont extraits du tableau 1 afin de mettre en évidence les relations existant entre les valeurs des signaux de sélection S0 à S7 et les bits d'adresse A2, A1, A0 lorsque ceux-ci sont à 1.

Il apparaît que le bit A2 ne dépend que de S0, S1, S2, S3, que le bit A1 ne dépend que de S0, S1, S4, S5 et que le bit A0 ne dépend que de S0, S2, S4, S6. On en déduit les relations suivantes :
(1) A2 = /S0*/S1*/S2*/S3
(2) A1 = /S0*/S1*/S4*/S5
(3) A0 = /S0*/S2*/S4*/S6
"*" étant la fonction ET, et "/" la fonction NON,

Les relations 1 à 3 peuvent également s'écrire au moyen de la fonction NON_OU :
(1') A2 = /(S0+S1+S2+S3)
(2') A1 = /(S0+S1+S4+S5)
(3') A0 = /(S0+S2+S4+S6)
"+" étant la fonction OU.

Le circuit ARCT1 est agencé pour mettre en oeuvre les relations 1, 2, 3 et comprend ici :
- huit noeuds d'entrée, prenant ici la forme de huit lignes horizontales HL0, HL1, ...HL7,
- trois noeuds de sortie, prenant ici la forme de trois lignes verticales VL0, VL1, VL2, et
- des portes inverseuses élémentaires IGxy, chaque porte inverseuse étant connectée à un noeud d'entrée HL0 à HL7 et à un noeud de sortie VL0, VL1, VL2, "x" étant le rang du noeud d'entrée (ligne horizontale) et "y" le rang du noeud de sortie (ligne verticale) auxquels la porte est connectée.

Chaque noeud d'entrée HL0, HL1...HL7 est relié à une ligne de contrôle CTL0, CTL1, ...CTL7 du plan mémoire MA et recopie le signal de contrôle S0, S1, ...S7 appliqué à la ligne de contrôle. La liaison entre les lignes de contrôle CTL0 à CTL7 et les noeuds d'entrée HL0 à HL7 peut être une simple connexion fil à fil, comme représenté sur la figure, ou une liaison par l'intermédiaire d'un circuit d'interface décrit plus loin.

Chaque porte inverseuse élémentaire IGxy est formée ici par un transistor TM de polarisation à l'état bas ("pull-down") de type NMOS. La grille du transistor TM forme l'entrée de la porte inverseuse et est reliée à l'un des noeuds d'entrée HL0 à HL7, le drain du transistor forme la sortie de la porte inverseuse et est relié à l'un des noeuds de sortie VL0 à VL2. La source du transistor est reliée à la masse. Par ailleurs, chaque noeud de sortie VL0 à VL2 est relié à un élément de polarisation à l'état haut ("pull-up"), ici une résistance R dont l'anode reçoit une tension Vcc . Chaque noeud de sortie VL0 à VL2 est ainsi maintenu par défaut à l'état haut et passe à l'état bas si au moins une porte inverseuse à laquelle il est relié commute à l'état bas (transistor TM passant).

Cet agencement de portes inverseuses élémentaires reliées à un noeud de sortie commun qui est polarisé à l'état haut, forme une fonction ET ayant ses entrées inversées, soit une fonction NON_OU relativement aux signaux S0 à S7.

Plus particulièrement, le circuit ARCT1 comprend ici trois groupes de portes inverseuses reliés respectivement aux noeuds de sortie VL0, VL1, VL2, qui forment trois portes NG2, NG1, NG0 de type NON_OU. La porte NG2 comprend des portes inverseuses IG02, IG12, IG22, IG32 dont les entrées reçoivent respectivement les signaux S0, S1, S2, S3 et dont les sorties sont connectées au noeud VL2. La porte NG2 fournit ainsi un bit d'adresse reconstitué RA2 qui correspond au bit A2, conformément à la relation 1. La porte NG1 comprend des portes inverseuses IG01, IG11, IG41, IG51 dont les entrées reçoivent respectivement les signaux S0, S1, S4, S5 et dont les sorties sont connectées au noeud VL1, et fournit un bit d'adresse reconstitué RA1 qui correspond au bit A1 conformément à la relation 2. Enfin, la porte NG0 comprend des portes inverseuses IG00, IG20, IG40, IG60 dont les entrées reçoivent respectivement les signaux S0, S2, S4, S6 et dont les sorties sont connectées au noeud VL0, et fournit un bit d'adresse reconstitué RA0 qui correspond au bit A0 conformément à la relation 3. Ensemble, les bits d'adresse reconstitués RA0, RA1, RA2 forment l'adresse reconstituée RADi.

Cette structure de circuit de reconstitution d'adresse ARCT1 est avantageuse en raison de sa simplicité. Elle repose sur l'obtention d'une fonction NON_OU en utilisant des interrupteurs de polarisation à l'état bas et des noeuds de sortie polarisés par défaut à l'état haut. Par ailleurs la prévision de lignes horizontales comme noeuds d'entrée et de lignes verticales comme noeuds de sortie est adaptée à l'implémentation du circuit ARCT1 dans le prolongement du plan mémoire.

Il sera noté que la dernière ligne horizontale HL7, bien que représentée sur la figure 2, n'est pas nécessaire ici pour la reconstitution de l'adresse "111". La ligne HL7 est par contre nécessaire pour produire une adresse formant le complément à 1 de l'adresse reconstituée RADi, cet aspect de l'invention étant décrit plus loin.

En pratique, l'emplacement des transistors de polarisation à l'état bas TM peut être déterminé sans étape de calcul en réorganisant le tableau 1 de manière à représenter les valeurs à 1 des bits d'adresse AD0 à AD2 comme une fonction des valeurs des signaux de sélection S0 à S7. On obtient le tableau 5 ci-après (Cf. Annexe), dans lequel chaque case correspond à une intersection d'une ligne horizontale HL0 à HL7 et d'une ligne verticale VL0 à VL2. A chaque case égale comportant la valeur 0 correspond un emplacement d'un interrupteur "pull-down" TM.

Le circuit de reconstitution d'adresse peut également être réalisé avec des interrupteurs de polarisation à l'état haut, ou interrupteurs "pull-up", formant des portes suiveuses, par exemple en reliant la source des transistors TM à l'une des lignes verticales VL0, VL1, VL2 et en appliquant la tension Vcc sur leur drain. Dans ce cas, les lignes VL0, VL1, VL2 sont polarisées par défaut à l'état bas, par exemple au moyen d'une résistance reliée à la masse. L'emplacement des interrupteurs "pull-up" est indiqué par le tableau 6 ci-après (Cf. Annexe). Chaque case du tableau 6 comportant la valeur 1 correspond à un emplacement d'un interrupteur à l'intersection d'une ligne verticale VL0, VL1, VL2 et d'une ligne horizontale HL0 à HL7. Ce mode de réalisation est applicable lorsque la tension des signaux de sélection Si est suffisante pour transférer la tension Vcc du drain à la source des transistors (ce qui est généralement le cas).

La figure 3 représente un circuit de reconstitution d'adresse ARCT2 réalisé suivant le même principe que le circuit ARCT1 mais généralisé à une structure de plan mémoire MA comprenant n lignes de contrôle CTL0, CTL1...CTLn-1 correspondant à p bits d'adresse A0 à Ap-1, avec n = 2^{P}.

Le circuit ARCT2 comprend ainsi des lignes horizontales HLi (HL0, HL1...HLn-1) formant des noeuds d'entrée et recopiant des signaux de sélection Si (S0, S1...Sn-1) du plan mémoire MA, des lignes verticales VL0 à VLp-1 formant des noeuds de sortie, polarisées à la tension Vcc par une résistance R, et des portes inverseuses élémentaires IGxy représentées schématiquement par des cercles, chaque porte inverseuse recevant l'un des signaux de sélection Si. Ces divers éléments forment comme précédemment des portes NON_OU élémentaires NG0 à NGp-1 fournissant les bits RA0 à RAp-1 de l'adresse reconstituée RADi.

En réponse au problème technique exposé au préambule, la comparaison de l'adresse reconstituée RADi et de l'adresse appliquée ADi permet de détecter une erreur d'un premier type se traduisant par l'activation dans le plan mémoire MA d'un signal de sélection Si et un seul, ne correspondant pas à celui qui est désigné par l'adresse ADi appliquée au décodeur ADEC.

Toutefois, cette comparaison ne permet pas de détecter une erreur d'un second type qui se traduirait par l'activation simultanée de deux signaux de sélection, car l'adresse reconstituée RADi pourrait dans ce cas continuer à correspondre à l'adresse appliquée ADi (Cf. tableau 5, en supposant par exemple que le signal S2 soit activé par le décodeur, mais que S3 soit simultanément activé par une injection d'erreur, l'adresse reconstituée étant celle de S2 car le signal S2 impose le 0 sur la ligne VL0).

Ainsi, selon un aspect optionnel mais avantageux de l'invention, le circuit ARCT2 comprend des portes NON_OU complémentaires CNGO à CNGp-1 permettant de détecter une erreur du second type. Les portes NON_OU complémentaires sont réalisées suivant la même architecture que les portes NON_OU "de base" (portes NG0 à NGp-1), en prévoyant des lignes verticales complémentaires CVL0 à CVLp-1 polarisées à l'état haut et des transistors "pull-down" formant des portes inverseuses élémentaires CIGxy dont les sorties sont reliées aux lignes verticales CVL0 à CVLp-1. Les entrées de chaque porte NON_OU complémentaire sont reliées aux lignes horizontales HL0 à HLn-1 auxquelles la porte NON_OU de base de rang correspondant n'est pas reliée. Par exemple, si une porte NON_OU de base est reliée aux lignes HL0 à HL4, la porte NON_OU complémentaire est reliée aux lignes HL5 à HLn-1.

Chaque porte NON_OU complémentaire fournit ainsi un bit d'adresse reconstitué inversé NRA0 à NRAp-1 dont la valeur logique est l'inverse de celle du bit d'adresse reconstitué RA0 à RAp-1 de rang correspondant. Les bits d'adresse reconstitués inversés NRA0 à NRAp-1 forment une adresse reconstituée NRADi qui est le complément à 1 (complément binaire) de l'adresse reconstituée RADi.

Chaque bit d'adresse reconstitué RA0 à RAp-1 est appliqué avec son complément NRA0 à NRAp-1 à l'entrée d'une porte XG0 à XGp-1 du type OU Exclusif. Les sorties des portes XG0 à XGp-1 sont appliquées à une porte AG11 de type NON ET ayant p entrées, dont la sortie fournit un signal d'erreur ER2.

En l'absence d'erreur du second type, la sortie de chaque porte XG0 à XGp-1 est à 1 puisque chaque porte reçoit un bit d'adresse reconstitué et son complément (le bit d'adresse reconstitué inversé). Le signal ER2 est alors à 0. Si une erreur du second type se produit, c'est-à-dire si au moins deux signaux de sélection S0 à Sn-1 sont activés simultanément sur les lignes de contrôle CTL0 à CTLn-1 du plan mémoire, ceci se traduit immanquablement par une égalité entre au moins un bit de l'adresse RADi et un bit de l'adresse complémentaire NRADi. Ainsi, l'une des portes XG0 à XGp-1 passe à 0 et le signal ER2 passe à 1.

Accessoirement, le signal ER2 permet également de détecter un troisième type d'erreur qui peut se produire si le décodeur d'adresse ne fournit aucun signal de sélection en réponse à l'adresse appliquée ADi. Dans ce cas, l'adresse RADi et son complément NRADi sont strictement identiques, de sorte que toutes les portes XG0 à XGp-1 passent à 0.

La figure 4 représente un exemple de réalisation du circuit de comparaison CMPCT1, prévu pour gérer à la fois les erreurs du premier, du second et du troisième type. Le circuit de comparaison comprend des portes XG10 à deux entrées de type OU Exclusif en recevant chacune un bit de l'adresse ADi appliquée au décodeur ADEC et un bit de l'adresse reconstituée RADi. Les sorties de toutes les portes XG10 sont appliquées à une porte OG1 de type OU dont la sortie fournit un signal d'erreur ER1 qui passe à 1 lorsque l'adresse reconstituée n'est pas égale à l'adresse appliquée. Le signal d'erreur ER1 est appliqué sur une entrée d'une porte OG2 de type OU dont l'autre entrée reçoit le signal d'erreur ER2. La sortie de la porte OG2 fournit le signal d'erreur ER qui est ainsi un signal d'erreur général passant à 1 lorsqu'une erreur du premier type ou du second type est détectée.

Pour synchroniser le signal d'erreur ER avec les cycles de lecture, celui-ci est appliqué à l'entrée D d'une bascule FF ayant une entrée d'horloge active sur front descendant qui reçoit un signal de déclenchement TG, par exemple le signal de lecture RD émis par le circuit de contrôle CCT. Sur front descendant du signal RD, marquant la fin d'un cycle de lecture, la sortie Q de la bascule FF recopie le signal d'erreur ER. La bascule présente également une entrée de remise à zéro recevant un signal RS assurant sa remise à zéro après détection et traitement d'une erreur.

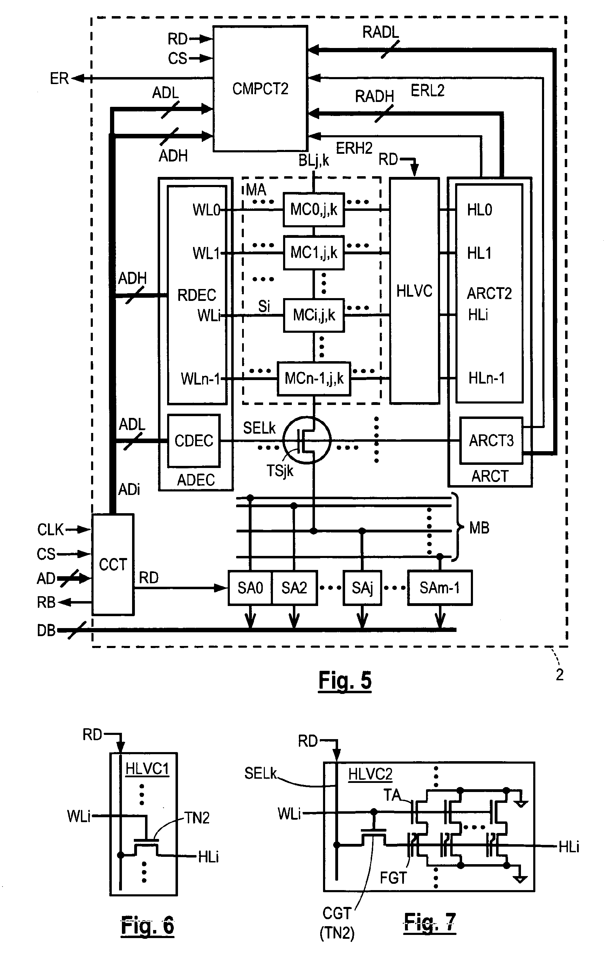

La figure 5 représente une application de l'invention à une mémoire 2 de type EEPROM comprenant, comme la mémoire 1, un plan mémoire MA, un circuit de contrôle CCT, un circuit de reconstitution d'adresse ARCT selon l'invention et un circuit de comparaison CMPCT2 selon l'invention.

Le plan mémoire MA comprend ici des cellules mémoire MCi,j,k effaçables et programmables électriquement qui sont connectées à des lignes de mot horizontales WLi et à des lignes de bit verticales BLj,k. Les lignes de bit sont regroupées en colonnes de rang k comprenant chacune m lignes de bit, i étant un indice de ligne de mot, j étant un indice de ligne de bit allant de 0 à m-1, m étant le nombre de bits par colonne, k étant un indice de colonne. Le plan mémoire définit ainsi, le long des lignes de mot WLi, des mots binaires de m bits chacun.

La mémoire comprend également m amplificateurs de lecture SAj (SAO à SAm-1) et chaque ligne de bit BLj,k est reliée à un amplificateur SAj par l'intermédiaire d'un transistor de sélection TSjk et d'un bus de multiplexage MB.

Le décodeur d'adresse ADEC comprend un décodeur de ligne de mot RDEC et un décodeur de colonne CDEC. Le décodeur de ligne de mot RDEC pilote les lignes de mot WLi au moyen des signaux de sélection Si décrits plus haut. Le décodeur de colonne CDEC fournit des signaux de sélection de colonne SELk qui sont appliqués aux transistors TSjk. Les transistors TSjk assurant la sélection des lignes de bit d'une même colonne, soit les transistors de même rang k, sont pilotés par le même signal SELk. Ainsi, sur sélection d'une ligne de mot WLi et d'une colonne de rang k, les amplificateurs de lecture SAj lisent les m cellules mémoire MCi,j,k du mot de rang i, k sélectionné. Les données lues sont fournies sur un bus de données DB.

Comme précédemment, le circuit de contrôle CCT reçoit une adresse AD de lecture, un signal d'horloge CLK, un signal de sélection CS, et fournit un signal d'occupation RB et le signal de lecture RD interne assurant notamment l'activation des amplificateurs de lecture. Le circuit CCT fournit également une adresse ADi de sélection de mot qui se décompose ici en une adresse de ligne de mot ADH appliquée au décodeur RDEC et une adresse de colonne ADL appliquée au décodeur CDEC, l'adresse ADH comprenant les bits de poids fort et l'adresse ADL les bits de poids faible de l'adresse ADi.

L'adresse ADi est généralement égale à l'adresse reçue AD mais des étapes de conversion d'adresse virtuelle en adresse physique peuvent intervenir au sein du circuit de contrôle CCT, dans certaines mémoires à entrelacement de données. En tout état de cause, on considère ici dans un souci de simplicité que l'adresse ADi et l'adresse AD sont identiques car même si elles ne le sont pas, elles demeurent liées par une relation de conversion connue.

Le circuit ARCT comprend ici un circuit ARCT2 de reconstitution de l'adresse de ligne de mot ADH, identique à celui décrit plus haut, dont les références sont conservées. Il comprend également, de façon optionnelle, un circuit ARCT3 de reconstitution de l'adresse de colonne, de même structure que le circuit ARCT2 mais recevant les signaux de sélection de colonne SELk en tant que signaux d'entrée.

Ainsi, le circuit ARCT2 fournit une adresse de ligne de mot reconstituée RADH et le circuit ARCT3 fournit une adresse de colonne reconstituée RADH, les deux adresses reconstituées formant ensemble une adresse de mot reconstituée RADi présumée correspondre à l'adresse ADi. Le circuit ARCT2 fournit également un signal d'erreur ERH2 dont la valeur active signale le cas échéant une erreur du second type au niveau de la sélection des lignes de mot, et le circuit ARCT3 fournit un signal d'erreur ERL2 dont la valeur active signale le cas échéant une erreur du second type au niveau de la sélection des colonnes. Le circuit ARCT3 étant d'une structure générale semblable au circuit ARCT2, il ne sera pas décrit en détail.

Le circuit de comparaison CMPCT2 fournit le signal d'erreur général ER et compare d'une part l'adresse ADH et l'adresse reconstituée RADH et d'autre part l'adresse ADL et l'adresse reconstituée RADL, tout en incorporant dans le signal d'erreur ER les signaux d'erreur ERH2 et ERL2. Le signal d'erreur ER passe ainsi à 1 si au moins une erreur sur les quatre types d'erreurs est détectée.

La mémoire 2 comprend en outre un circuit d'interface HLVC pour isoler le plan mémoire MA du circuit ARCT2 en dehors des phases de lecture, notamment pendant des phases de programmation. Le circuit HLVC est interposé entre les lignes de mot WLi et les entrées du circuit ARCT2 (lignes horizontales HLi). Il peut comprendre, si nécessaire, des moyens pour convertir la tension des signaux de sélection Si appliqués aux lignes de mot WLi en une tension de plus faible valeur.

La figure 6 représente partiellement un mode de réalisation HLVC1 du circuit d'interface incluant une fonction de conversion de tension. Le circuit HLVC1 comprend, pour chaque ligne de mot WLi, un transistor NMOS TN2 dont la grille est connectée à la ligne de mot WLi, dont le drain reçoit le signal de lecture RD émis par le circuit de contrôle CCT et dont la source est connectée à la HLi correspondante du circuit ARCT2 (noeud d'entrée, CF. fig. 2 ou 3).

Quand le signal RD est à 0, le transistor TN2 est bloqué et le circuit HLVC1 isole le circuit ARCT2 du plan mémoire MA. Lorsque le signal RD est à 1 (phase de lecture) et que la ligne de mot WLi est sélectionnée (signal de sélection Si à la valeur active) le transistor TN2 devient passant et fournit à la ligne HLi une tension électrique qui est sensiblement égale à la tension du signal RD (en négligeant la chute de tension dans le transistor TN2), laquelle est généralement inférieure à celle des signaux de sélection Si appliqués à la ligne de mot WLi.

La figure 7 illustre un mode de réalisation d'un circuit d'interface HLVC2 dans lequel on utilise avantageusement des structures de cellules mémoire factices se trouvant sur les bords du plan mémoire MA, pour former les transistors TN2 de conversion du niveau de tension. Ces cellules mémoire factices sont généralement prévues en bordure du plan mémoire pour s'affranchir des effets dits "de bord". Un groupe de cellules mémoire factices formant un mot binaire est représenté en figure 7. Chaque cellule mémoire, de type EEPROM, comprend classiquement un transistor à grille flottante FGT et un transistor d'accès TA. Les grilles des transistors d'accès sont reliées par une ligne commune, et les grilles des transistors FGT sont connectées à la source d'un transistor de contrôle de grille CGT commun. Ce dernier a sa grille connectée à la ligne commune et son drain relié à une ligne SELk de sélection de colonne (qui n'est pas reliée aux organes de contrôle du plan mémoire).

Ainsi, pour réaliser le circuit d'interface HLVC2, on connecte à la masse les drains des transistors d'accès TA et les sources des transistors FGT des cellules mémoire factices. On applique le signal de lecture RD sur la ligne SELk connectée au drain du transistor CGT et on connecte la source du transistor CGT à l'entrée HLi correspondante du circuit ARCT2. Dans ces conditions, l'encombrement du circuit d'interface HLVC2 peut être considéré comme nul puisque celui-ci est implanté dans une zone du plan mémoire qui normalement n'est pas utilisée.

L'encombrement du circuit ARCT2, en terme de surface de silicium occupée, est principalement déterminé en "hauteur" par les lignes horizontales HL0 à HLn-1 (noeuds d'entrée), et plus particulièrement par le nombre de lignes horizontales et leur espacement. De même, l'encombrement du circuit ARCT2 en "largeur " est principalement déterminé par le nombre et l'espacement des lignes verticales VL0 à VLp-1 et CVL0 à CVLp-1 (noeuds de sortie). Or, même avec une mémoire nécessitant des tensions de lecture relativement élevées sur les lignes de mot, le circuit d'interface HLVC permet l'utilisation de transistors d'encodage basse tension de faible encombrement. L'utilisation de tels transistors laisse donc des espaces libres entre les lignes horizontales HLi, dont le nombre et l'écartement est imposé par les lignes de mot du plan mémoire MA.

Ici, une idée de l'invention est d'utiliser l'espace disponible entre les lignes horizontales pour réduire la largeur de la surface occupée par le circuit ARCT2 en diminuant, par exemple de moitié, le nombre de lignes verticales VL0 à VLp-1 et CVL0 à CVLp-1.

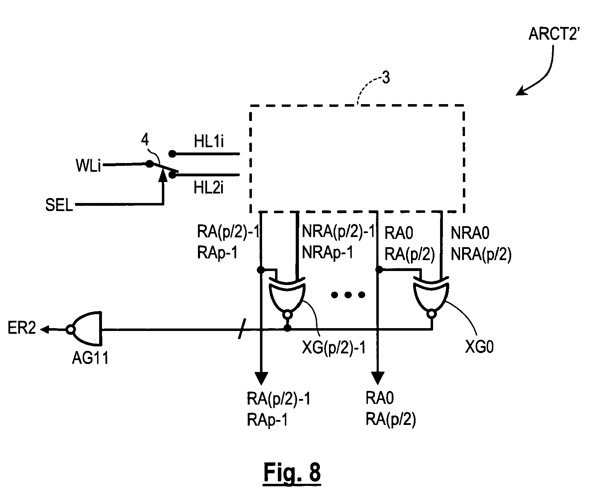

La structure du circuit ARCT2 peut notamment être modifiée de la manière illustrée sur la figure 8, en supposant ici que le nombre p de bits d'adresse à reconstituer est pair. Le circuit ARCT2' représenté en figure 8 comprend une matrice de reconstitution d'adresse représentée schématiquement sous la forme d'un bloc 3, qui est dérivée de celle représentée sur la figure 3 et comprend deux lignes horizontales HL1i et HL2i pour chaque ligne de mot WLi du plan mémoire. En contrepartie, le nombre de lignes verticales (soit le nombre de porte NON_OU élémentaires) est divisé par deux.

Plus particulièrement, les transistors d'encodage de deux bits d'adresse différents sont reliés à la même ligne verticale (soit au même noeud de sortie), les grilles des transistors d'encodage du premier bit d'adresse sont connectées aux lignes horizontales HL1i et les grilles des transistors d'encodage du second bit d'adresse sont connectées aux lignes horizontales HL2i, formant ainsi deux modules différents de reconstitution d'adresse. Des commutateurs 4 permettent de relier sélectivement chaque ligne de mot WLi à la ligne HL1i ou à la ligne HL2i en fonction de la valeur d'un signal de sélection SEL, de sorte que les transistors de deux modules de reconstitution d'adresse différents ne peuvent être actifs en même temps.

Selon la position des commutateurs 4, le circuit de reconstitution d'adresse ARCT2 fournit soit les bits de poids fort soit les bits de poids faible de l'adresse reconstituée RADi ou ADH. Les commutateurs 4 sont commandés au cours d'un premier cycle pour relier les lignes HL1i (i = 0 à n-1) aux lignes de mot WLi et obtenir des bits d'adresse RA0 à RA(p/2)-1, soit les bits de poids faible de l'adresse reconstituée, ainsi que leurs compléments. Au cours d'un second cycle, les commutateurs 4 sont commandés pour relier les lignes HL2i aux lignes de mot WLi et obtenir les bits de poids fort RA(p/2) à RAp-1 de l'adresse RADi et leurs compléments. Les deux cycles de reconstitution d'adresse sont effectués durant deux cycles de lecture d'une donnée dans la mémoire, ou durant le même cycle de lecture.

A la lumière des exemples décrits ci-dessus, il apparaîtra clairement à l'homme de l'art que le procédé selon l'invention est susceptible de diverses variantes de mise en oeuvre et de diverses applications. Les relations (1) à (3) ou (1') à (3') décrites plus haut montrent qu'un circuit logique conventionnel peut être utilisé pour fournir l'adresse reconstituée, au lieu d'interrupteurs de polarisation à l'état bas ou de polarisation à l'état haut.

Par ailleurs, l'exploitation de l'adresse reconstituée en tant qu'information permettant de détecter une erreur de lecture, peut être faite à l'extérieur de la mémoire. Dans ce cas, la mémoire ne comprend qu'une sortie spécifique pour fournir l'adresse RADi ainsi que son complément NRADi. L'unité de traitement qui utilise la mémoire peut par exemple effectuer elle-même la comparaison des adresses et prendre toute mesure appropriée en cas d'erreur de comparaison, par exemple de manière logicielle.

Une telle comparaison externe peut être faite en sus de la comparaison interne effectuée par le circuit de comparaison CMPCT1, CMPCT2, ou en remplacement de la comparaison interne. Le cumul d'une comparaison interne et externe peut présenter l'avantage de permettre une détection d'une injection d'erreur entre l'entrée de la mémoire recevant l'adresse AD et les entrées des décodeurs recevant l'adresse ADi, par exemple une injection d'erreur dans le circuit de contrôle CCT ou dans un registre d'adresse. Si l'adresse ADi est le résultat d'une conversion de l'adresse appliquée AD, l'unité de traitement doit appliquer la fonction de conversion inverse à l'adresse reconstituée RADi fournie par la mémoire avant de la comparer à l'adresse AD, ou doit appliquer la fonction de conversion à l'adresse AD avant de la comparer à l'adresse ADi.

Toute mesure appropriée autre que celles mentionnées plus haut peut être prise en cas de détection d'erreur, par exemple l'effacement de données sensibles dans la mémoire. Si l'erreur est signalée à une unité de traitement, par exemple un microprocesseur, une réinitialisation de l'unité de traitement voire la mise hors service définitive du circuit intégré incorporant la mémoire peut être prévue.

Les entrées des circuits de reconstitution d'adresse sont de préférence connectées aux extrémités des lignes de mot WLi et des lignes de sélection de colonne, à l'opposé des sorties des décodeurs, comme cela a été décrit dans ce qui précède, ce qui permet de détecter des perturbations introduites soit dans les décodeurs eux-mêmes soit au niveau des lignes de mot ou des lignes de sélection de colonne. Toutefois ces entrées peuvent également être connectées en des points des décodeurs où des variations de tension peuvent être détectées et où les niveaux de tension sont compatibles avec l'utilisation de transistors basse tension sans adaptation de tension.

Le circuit d'interface HLVC peut également être réalisé avec des interrupteurs ayant seulement pour fonction d'isoler les circuits de reconstitution d'adresse des lignes de mot et des lignes de sélection de colonne en dehors des cycles de lecture de la mémoire, notamment durant des cycles d'écriture de la mémoire où des tensions élevées de programmation et d'effacement sont appliquées sur ces lignes de contrôle.

### ANNEXE faisant partie intégrante de la description

**Tableau 1**

| ADi | | | Signaux de sélection | | | | | | | |
|---|---|---|---|---|---|---|---|---|---|---|
| A2 | A1 | A0 | S0 | S1 | S2 | S3 | S4 | S5 | S6 | S7 |
| 0 | 0 | 0 | 1 | 0 | 0 | 0 | 0 | 0 | 0 | 0 |
| 0 | 0 | 1 | 0 | 1 | 0 | 0 | 0 | 0 | 0 | 0 |
| 0 | 1 | 0 | 0 | 0 | 1 | 0 | 0 | 0 | 0 | 0 |
| 0 | 1 | 1 | 0 | 0 | 0 | 1 | 0 | 0 | 0 | 0 |
| 1 | 0 | 0 | 0 | 0 | 0 | 0 | 1 | 0 | 0 | 0 |
| 1 | 0 | 1 | 0 | 0 | 0 | 0 | 0 | 1 | 0 | 0 |
| 1 | 1 | 0 | 0 | 0 | 0 | 0 | 0 | 0 | 1 | 0 |
| 1 | 1 | 1 | 0 | 0 | 0 | 0 | 0 | 0 | 0 | 1 |

**Tableau 2**

| S0 | S1 | S2 | S3 | S4 | S5 | S6 | S7 | A2 |
|---|---|---|---|---|---|---|---|---|
| 0 | 0 | 0 | 0 | 1 | 0 | 0 | 0 | 1 |
| 0 | 0 | 0 | 0 | 0 | 1 | 0 | 0 | 1 |
| 0 | 0 | 0 | 0 | 0 | 0 | 1 | 0 | 1 |
| 0 | 0 | 0 | 0 | 0 | 0 | 0 | 1 | 1 |

**Tableau 3**

| S0 | S1 | S2 | S3 | S4 | S5 | S6 | S7 | A1 |
|---|---|---|---|---|---|---|---|---|
| 0 | 0 | 1 | 0 | 0 | 0 | 0 | 0 | 1 |
| 0 | 0 | 0 | 1 | 0 | 0 | 0 | 0 | 1 |
| 0 | 0 | 0 | 0 | 0 | 0 | 1 | 0 | 1 |
| 0 | 0 | 0 | 0 | 0 | 0 | 0 | 1 | 1 |

**Tableau 4**

| S0 | S1 | S2 | S3 | S4 | S5 | S6 | S7 | A0 |
|---|---|---|---|---|---|---|---|---|
| 0 | 1 | 0 | 0 | 0 | 0 | 0 | 0 | 1 |
| 0 | 0 | 0 | 1 | 0 | 0 | 0 | 0 | 1 |
| 0 | 0 | 0 | 0 | 0 | 1 | 0 | 0 | 1 |
| 0 | 0 | 0 | 0 | 0 | 0 | 0 | 1 | 1 |

**Tableau 5 (encodage avec des interrupteurs "pull-down")**

| Si | A2 (VL2) | A1 (VL1) | A0 (VL0) |
|---|---|---|---|
| S0= 1 (HL0) | 0 | 0 | 0 |
| S1= 1 (HL1) | 0 | 0 | 1 |
| S2= 1 (HL2) | 0 | 1 | 0 |
| S3= 1 (HL3) | 0 | 1 | 1 |
| S4= 1 (HL4) | 1 | 0 | 0 |
| S5= 1 (HL5) | 1 | 0 | 1 |
| S6= 1 (HL6) | 1 | 1 | 0 |
| S7= 1 (HL7) | 1 | 1 | 1 |

**Tableau 6 (encodage avec des interrupteurs "pull-up")**

| Si | A2 (VL2) | A1 (VL1) | A0 (VL0) |
|---|---|---|---|
| S0= 1 (HL0) | 0 | 0 | 0 |
| S1= 1 (HL1) | 0 | 0 | 1 |
| S2= 1 (HL2) | 0 | 1 | 0 |
| S3= 1 (HL3) | 0 | 1 | 1 |
| S4= 1 (HL4) | 1 | 0 | 0 |
| S5= 1 (HL5) | 1 | 0 | 1 |
| S6= 1 (HL6) | 1 | 1 | 0 |
| S7= 1 (HL7) | 1 | 1 | 1 |

## Revendications

1. Procédé de lecture d'une donnée dans une mémoire (1, 2) comprenant des cellules mémoire (MC) agencées dans un plan mémoire (MA), comprenant des étapes d'application au plan mémoire de signaux (Si, SELk) de sélection de cellules mémoire (MC) en fonction d'une adresse de lecture (ADi, ADH, ADL) appliquée à la mémoire, et de reconstitution d'au moins une partie (ADi, ADH, ADL) de l'adresse de lecture à partir des signaux (Si, SELk) de sélection de cellules mémoire, pour obtenir une première adresse reconstituée (RADi, RADH, RADL),
**caractérisé en ce qu'**un bit (RA0 à RAp-1, NRA0 à NRAp-1) de l'adresse reconstituée (RADi, NRADi) est reconstitué au moyen d'interrupteurs (TM, IGxy) agencés pour polariser à un premier état logique, un noeud de sortie (VL1 à VLp-1) commun polarisé par défaut à un second état logique, et en appliquant les signaux (Si, SELk) de sélection de cellules mémoire (MC) sur des bornes de contrôle des interrupteurs (TM).

2. Procédé selon la revendication 1, comprenant les étapes consistant à :
- comparer (CMPCT1, CMPCT2) la première adresse reconstituée (RADi, RADH, RADL) avec au moins une partie (ADi, ADH, ADL) de l'adresse de lecture, et
- activer un premier signal d'erreur (ER1) si l'adresse reconstituée est différente de l'adresse de lecture.

3. Procédé selon l'une des revendications 1 à 2, comprenant des étapes consistant à :
- produire, à partir des signaux de sélection (Si, SELk), une seconde adresse reconstituée (NRADi) qui forme le complément à 1 de la première adresse reconstituée (RADi),
- comparer la première (RADi) et la seconde (NRADi) adresses reconstituées, et
- activer un second signal d'erreur (ER2) si au moins l'un des bits de la seconde adresse reconstituée (NRADi) est égal à un bit de même rang de la première adresse reconstituée (RADi).

4. Procédé selon l'une des revendications 2 et 3, comprenant l'activation d'un signal d'erreur général (ER) si au moins l'un des deux signaux d'erreur (ER1, ER2) est activé.

5. Procédé selon l'une des revendications 1 à 4, dans lequel l'adresse reconstituée (RADi) comprend le même nombre de bits que l'adresse de lecture (ADi).

6. Procédé selon l'une des revendications 1 à 5, dans lequel les signaux de sélection (Si, SELk) sont transformés en signaux basse tension avant d'être appliqués aux bornes de contrôle des interrupteurs (TM).

7. Procédé selon l'une des revendications 1 à 6, appliqué à une mémoire (1) comprenant :
- un plan mémoire (MA) comportant des cellules mémoire (MCi,j,k) connectées à des lignes de mot (WLi) et à des lignes de bit (BLj,k), les lignes de bit étant agencées en colonnes pour former des colonnes,
- un décodeur de ligne (RDEC) fournissant des signaux (Si) de sélection de ligne de mot (WLi) en fonction de l'adresse de lecture (ADi),
- un décodeur de colonne (CDEC) fournissant des signaux (SELk) de sélection de colonne en fonction de l'adresse de lecture (ADi),
dans lequel l'adresse reconstituée (RADi) est déterminée à la fois à partir des signaux (Si) de sélection de ligne de mot et des signaux (SELk) de sélection de colonne.

8. Mémoire (1, 2) comprenant des cellules mémoire (MC) agencées dans un plan mémoire (MA), un décodeur d'adresse (ADEC, RDEC, CDEC) pour appliquer au plan mémoire des signaux (Si, SELk) de sélection de cellules mémoire (MC) en fonction d'une adresse de lecture (ADi, ADH, ADL) appliquée à la mémoire, et un circuit de reconstitution d'adresse (ARCT, ARCT1, ARCT2, ARCT2', ARCT3) qui fournit une première adresse reconstituée (RADi, RADH, RADL) reconstituant au moins une partie (ADi, ADH, ADL) de l'adresse de lecture à partir des signaux (Si, SELk) de sélection de cellules mémoire,
**caractérisée en ce que** le circuit de reconstitution d'adresse (ARCT, ARCT1, ARCT2, ARCT2', ARCT3) comprend :
- au moins un groupe d'interrupteurs (TM, IGxy) agencés pour polariser à un premier état logique, un noeud de sortie (VL1 à VLp-1) commun aux interrupteurs, qui fournit un bit (RA0 à RAp-1, NRA0 à NRAp-1) de l'adresse reconstituée (RADi, NRADi), et
- un élément (R) pour polariser par défaut le noeud de sortie (VL1 à VLp-1) à un second état logique, et
- des moyens pour appliquer directement ou indirectement à des bornes de contrôle des interrupteurs (TM) des signaux (Si, SELk) de sélection de cellules mémoire (MC).

9. Mémoire (1, 2) selon la revendication 8, comprenant un circuit de comparaison (CMPCT1, CMPT2) qui compare l'adresse reconstituée (RADi, RADH, RADL) avec au moins une partie (ADi, ADH, ADL) de l'adresse de lecture, et qui active un premier signal d'erreur (ER1) si l'adresse reconstituée est différente de l'adresse de lecture.

10. Mémoire (1, 2) selon l'une des revendications 8 et 9, dans laquelle le circuit de reconstitution d'adresse (ARCT2, ARCT2', ARCTC3) fournit également une seconde adresse reconstituée (NRADi) qui forme le complément à 1 de la première adresse reconstituée (RADi).

11. Mémoire (1, 2) selon la revendication 10, comprenant un circuit de comparaison (CMPCT1, CMPT2) qui compare la première (RADi) et la seconde (NRADi) adresses reconstituées, et active un second signal d'erreur (ER2) si au moins l'un des bits de la seconde adresse reconstituée (NRADi) est égal à un bit de même rang de la première adresse reconstituée (RADi).

12. Mémoire (1, 2) selon l'une des revendications 8 à 11, dans laquelle le circuit de reconstitution d'adresse (ARCT, ARCT1, ARCT2, ARCT2', ARCT3) comprend des modules de reconstitution d'adresse ayant des sorties communes et fonctionnant en alternance pour fournir en alternance différentes parties de l'adresse reconstituée.

13. Mémoire (1, 2) selon l'une des revendications 8 à 12, comprenant :
- un plan mémoire (MA) comportant des cellules mémoire (MCi,j,k) connectées à des lignes de mot (WLi) et à des lignes de bit (BLj,k), les lignes de bit étant agencées en colonnes pour former des colonnes de mot,
- un décodeur de ligne (RDEC) fournissant des signaux (Si) de sélection de ligne de mot en fonction de l'adresse de lecture (ADi),
- un décodeur de colonne (CDEC) fournissant des signaux (SELk) de sélection de colonne en fonction de l'adresse de lecture (ADi),
- un circuit (ARCT2, ARCT2') de reconstitution d'une adresse de ligne de mot (ADH), fournissant une adresse de ligne de mot reconstituée (RADH) à partir des signaux (Si) de sélection de ligne de mot, et
- un circuit (ARCT3) de reconstitution d'une adresse de colonne (ADL), fournissant une adresse de colonne reconstituée (RADL) à partir des signaux (SELk) de sélection de colonne.

14. Mémoire (1, 2) selon l'une des revendications 8 à 13, comprenant un circuit d'interface (HLVC) pour isoler le circuit de reconstitution d'adresse (ARCT, ARCT1, ARCT2, ARCT2', ARCT3) des signaux de sélection appliqués au plan mémoire lorsque la mémoire n'est pas en phase de lecture du plan mémoire.

15. Mémoire (1, 2) selon l'une des revendications 8 à 14, comprenant un circuit d'interface (HLVC, TN2, CGT) pour abaisser la tension des signaux de sélection appliqués au plan mémoire avant de les appliquer au circuit de reconstitution d'adresse.

16. Mémoire (1, 2) selon l'une des revendications 16 et 17, dans laquelle le circuit d'interface (HLVC) comprend des composants (CGT) de cellules mémoire non utilisées présentes sur des bords du plan mémoire (MA).
